(19)

Europäisches
Patentamt

European
Patent Office

Office européen
des brevets

(11) **EP 2 672 282 A1**

(12) **EUROPEAN PATENT APPLICATION**

(43) Date of publication:
**11.12.2013 Bulletin 2013/50**

(51) Int Cl.:
*G01R 31/02* *(2006.01)*

(21) Application number: **12171153.5**

(22) Date of filing: **07.06.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Oy**
**00380 Helsinki (FI)**

(72) Inventor: **Bäckström, Filip**
**00380 Helsinki (FI)**

(74) Representative: **Kolster Oy Ab**
**Iso Roobertinkatu 23**
**PO Box 148**
**00121 Helsinki (FI)**

(54) **Earth fault detection in frequency converter**

(57)    An earth fault detection circuit for a frequency converter. The earth fault detection circuit comprises a Rogowski coil integrated on a circuit board. The Rogowski coil is adapted to produce a voltage signal representing a summation current of an input of the frequency converter or a summation current in the intermediate DC link.

FIG 3

**EP 2 672 282 A1**

**Description**

FIELD OF THE INVENTION

The present invention relates to frequency converters, and more particularly to earth fault detection in frequency converters.

BACKGROUND OF THE INVENTION

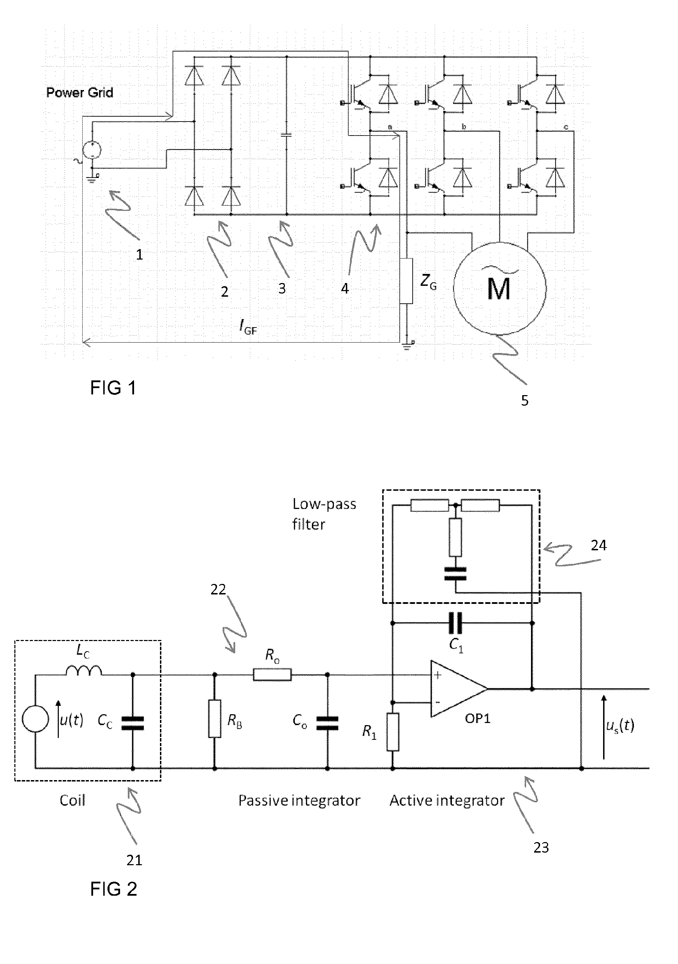

A frequency converter is a converter device which is typically used for driving a load, such as an electrical motor. Figure 1 shows a main circuit of an example of a frequency converter. In Figure 1 the frequency converter is connected to an alternating mains voltage 1. The alternating voltage is rectified to a DC voltage to an intermediate voltage circuit 3 using a rectifier 2 and the DC voltage from the intermediate voltage circuit is further inverted to an AC voltage using an inverter bridge 4. The inverter bridge 4 in the frequency converter produces an output voltage with a desired fundamental frequency and phase voltage. The ability to control the frequency and amplitude of the fundamental output voltage wave allows an increased controllability of the electrical motor as compared with the motor being connected directly to an AC supply grid. Modern frequency converters can drive their loads in a variety of manners. They may be used for controlling the rotation speed or torque of the load, for example. The increased control of the load 5 has several advantages, such as driving the load in a more economical way.

An earth fault in the output phases of a frequency converter may occur due to a failure of the insulation in either the motor cable or the motor. The earth fault composes a current loop, as illustrated in Figure 1. The ground potential operates as a return path of the current, causing a leakage current $I_{GF}$. In a grounded power grid, a low impedance ground fault causes high currents that break the semiconductor components of the frequency converter. Furthermore, the leakage current caused by a high impedance earth fault may cause problems in the motor control. The earth fault causes a current in either positive or negative DC arms of an intermediate DC link, depending on the state of the inverter leg of the output phase with the earth fault. Hence, an earth-fault detection should detect a fault current flowing in both of the DC arms in order to prevent damages in the IGBTs. The earth fault detection of a frequency converter is designed to detect earth faults at the output phases of the converter. The detection can be implemented either by control software of the converter or hardware-based detection. In software-based earth fault detection, the leakage current can be detected utilizing a zero-vector switching as disclosed in US 5,214,575. During a zero-vector switching, all the three output phases are connected to the same DC potential. A motor current supplied by the intermediate DC link to the inverter stage will decrease to zero after a finite transient time. Hence, the intermediate DC link provides the inverter bridge only with the earth fault current. The earth fault detection circuit utilizes this fact. The detection circuit measures the current between the intermediate DC link and inverter stage during the zero vector in order to distinguish the earth fault current from the supplied motor current.

US 5,214,575 presents an earth fault protection scheme utilizing current measurement shunts in both the positive and negative DC link potentials. The current measurement shunts are placed between the intermediate DC link and the inverter bridge. A current exceeding an over-current threshold value will give an over-current signal, which is compared with the states of the active switches. If an over-current signal occurs during a zero vector, the fault is treated as an earth fault. Otherwise, the fault is classed as an over-current fault.

Another way to detect an earth fault is to measure a summation current either at the intermediate DC link, output phases or input phases as is described in US 7,663,850. The summation current measurement reveals a leakage current produced by the earth fault. The measurement can be implemented utilizing a summation current transformer. Another way to determine the summation current is to measure the current separately in the DC potentials or output phases. The separately measured current signals can then be summated utilizing an analog electronic circuit.

The problem with summation current transformers is the requirement for a bulky and expensive structure. The price of a transformer comprises windings and core made of a ferrite material. The ferrite materials saturate easily, which has to be taken into account when dimensioning the transformer. The saturation of the magnetic core sets a lower limit to the physical size of the transformer. In the earth fault detection circuit based on the current measurement of the output phases, the required equipment is bulky and expensive. For reliable protection against high earth fault currents, the currents of all output phases have to be measured using galvanically isolated current sensors.

The method in which the current is measured during a zero voltage vector provides good results even with high impedance earth faults. Further, the method can be implemented with low component costs. However, the high impedance earth fault detection cannot be used with high switching frequencies or with high output frequencies due to the short duration of the zero vectors.

BRIEF DESCRIPTION OF THE INVENTION

An object of the present invention is to provide a detection circuit so as to solve the above problem. The objects of the invention are achieved by a circuit which is characterized by what is stated in the independent claim. Preferred embodiments of the invention are disclosed in the dependent claims.

The invention is based on using a Rogowski coil integrated on a printed circuit board. The Rogowski coil is used for measuring a summation current in a frequency converter. The summation current may be measured either by measuring the summation current of the input of the frequency converter or the summation current in an intermediate DC link. The output of the secondary turns of the Rogowski coil is preferably integrated with a combination of a passive and an active integrator for producing a wide operating frequency bandwidth. An alternative solution is to utilize only a passive integrator or an active integrator to integrate the output voltage of the Rogowski coil, but this decreases the operation bandwidth of the sensing circuit as compared with the combination of active and passive integrators.

With the circuit of the invention it is possible to detect earth faults with high impedances that may disturb the control of the frequency converter. Further, the circuit of the invention enables large earth fault currents to be detected quickly when the impedance in the route of the earth fault is low.

The detection circuit utilizing the Rogowski coil can be implemented with low component costs. The Rogowski coil is implanted on the printed circuit board, which eliminates costs related to the magnetic core of the summation current transformer and winding of the core.

The utilization of the air core in the Rogowski coil removes the issues related to saturation of the magnetic core, enabling utilization of the same design in a wide range of frequency converter power levels. Additionally, the Rogowski coil can be integrated on existing printed circuit boards of the converter, making utilization of the PCB based Rogowski coil a compact solution for the earth fault detection.

BRIEF DESCRIPTION OF THE DRAWINGS

In the following, the invention will be described in greater detail by means of preferred embodiments and with reference to the accompanying drawings, in which

Figure 1 shows a main circuit of a frequency converter;
Figure 2 shows an example of an earth fault detection circuit;
Figure 3 shows alternative positions for an earth fault detection circuit; and
Figure 4 shows an example of a Rogowski coil.

DETAILED DESCRIPTION OF THE INVENTION

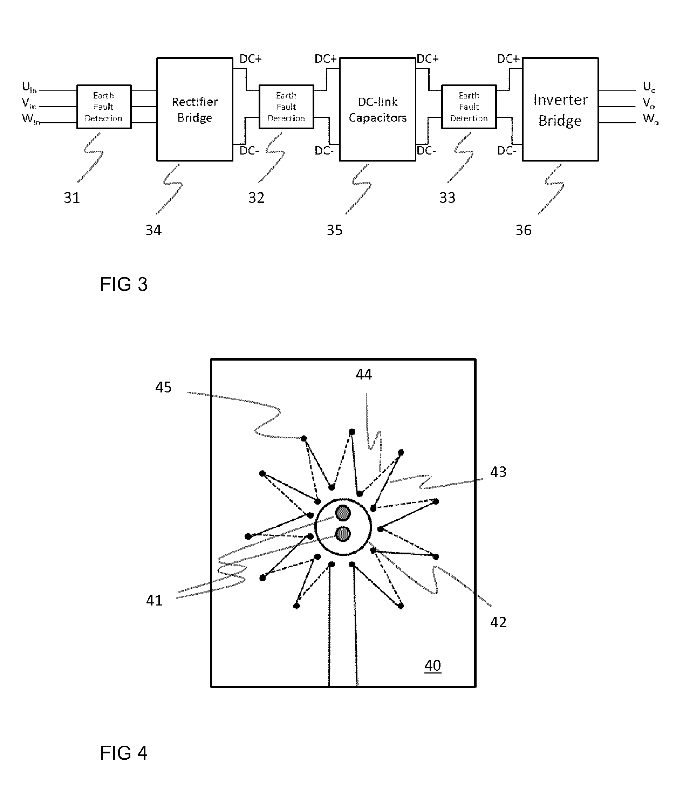

According to the earth fault detection circuit for a frequency converter of the present invention, the circuit comprises a Rogowski coil integrated on in a printed circuit board. The winding of the Rogowski coil is implemented on a printed circuit board 40 utilizing traces 43, 44 and vias 45 as shown in Figure 4. The coil is formed in such a manner that the primary turns, i.e. conductors 41 of the measured currents, of a transformer can be passed through the center 42 of the Rogowski coil. This can be implemented either by passing wires through a hole in the center of the coil or by printed circuit board traces 43, 44 on two outer layers routed through center vias in the center of the Rogowski coil. The dotted lines in Figure 4 are the traces 44 on the back of the printed circuit board and the solid lines are the traces 43 on the visible surface of the board. An example of such a Rogowski coil is presented in US 5,414,400.

The Rogowski coil is adapted to produce a voltage signal representing a summation current of measured conductors. This is to say that either the input line conductors or the DC link conductors are passed through the center of the Rogowski coil in the circuit board. The input line conductors may comprise a phase and neutral conductors if the frequency converter is connected to a single-phase AC supply, or they may comprise all three supplying phase conductors when the frequency converter is connected to a three-phase AC supply. The summation current can also be measured from the DC link conductors either between the rectifier and the DC link capacitors or between the intermediate DC link capacitors and the inverter bridge by passing the conductors of both positive and negative DC arms through the center of the coil. The summation current is a sum of the currents flowing through the Rogowski coil. If the summation current exceeds a predetermined threshold value, the leakage current is interpreted to be caused by an earth fault.

Figure 3 shows alternatives for measuring the summation current. In Figure 3, a three-phase frequency converter obtains inputs $U_{in}$, $V_{in}$, $W_{in}$ and produces output voltages $U_o$, $V_o$, $W_o$. The measurement of the summation current and the earth fault detection can be situated at an input 31 of the frequency converter. As seen in Figure 3, all input phases are led to a detector circuit 31. Alternatively, the summation earth fault detection 32 may operate to measure a summation current between a rectifier bridge 34 and a DC link capacitors 35. Further, an earth fault detection circuit 33 may alternatively be situated between the DC capacitors 35 and an inverter bridge 36. In the last two alternatives, the current is measured from DC rails DC+, DC-.

As is known, a Rogowski coil is a magnetic current sensor utilizing an air core. The Rogowski coil does not utilize any magnetic core, which gives it several advantages. It has high linearity, high frequency bandwidth and it does not suffer from saturation of the magnetic material. The measured current induces a low voltage in the sensor having a voltage value that is typically in a range of few mV/A.

In a preferred embodiment of the invention, a combination of a passive integrator circuit and an active integrator circuit is adapted to receive a voltage signal representing the summation current from the Rogowski coil. The integration times of the passive and active integrators are matched. The combination of the integrators produce a voltage signal. This signal is compared with a set voltage limit, and once the voltage limit is exceeded, it is concluded that current is leaking to the ground and an earth fault is present. The comparison between the produced signal and a set limit value can be made by a comparator circuit. Another solution is to provide the signal directly to the DSP unit carrying out the comparison. Once the limit is exceeded, the frequency converter may produce an alarm signal and/or bring the system down in a controlled manner.

As is known, the operation of the Rogowski coil is based on Ampere's law. The expression of the induced voltage is

$$u(t) = M \frac{\mathrm{d}i(t)}{\mathrm{d}t}, \qquad (1)$$

where M is the coupling inductance of the coil. For a concentric coil with a rectangular cross-section, the coupling inductance is

$$M = \mu_0 \frac{Nd}{2\pi} \ln \frac{b}{a}, \qquad (2)$$

where N is the number of turns, d is the height of the winding, a is the inner radius of the winding, and b is the outer radius of the winding.

An integrator of the output signal of the Rogowski coil produces a frequency independent analog current sensing signal for a certain frequency bandwidth. Ray, W.F. and Davis, R.M. 1999. High Frequency Improvements in Wide Bandwidth Rogowski Current Transducer, European Power Electronics Conference, Conference Proceedings, Lausanne, propose utilization of a combination of both a passive and an active integrator for a wide bandwidth output. This circuit is illustrated in Figure 2. The passive integrator 22 consists of $R_o C_o$ in Figure 2. The passive integrator provides a good high-frequency performance. However, the RC integrator operates as an integrator for frequencies exceeding the RC cutoff frequency. This feature restrains its low-frequency performance. On the other hand, the high-frequency performance of the active integrator 23 is limited by the gain-bandwidth of the operational amplifier. Hence, the combination eliminates the limitations of both the active and passive integrators.

The passive and active integrators are connected in series. That is to say that the output from the passive integrator 22 is fed to the active integrator 23. As is understood, the passive integrator formed of an RC circuit has a unity gain in lower frequencies while the active integrator, formed of resistance $R_1$ and capacitance $C_1$ together with the operational amplifier $OP_1$, is dimensioned to give a unity gain at higher frequencies.

The Rogowski coil is shown in Figure 2 as a voltage source u(t) and as series inductance $L_c$ and parallel capacitance $C_c$. The Rogowski coil's inductance $L_c$ and parasitic capacitance $C_c$ compose an LC circuit. In order to avoid oscillation of the LC circuit, the coil should be match-terminated by a resistor. In Figure 2, this matching resistor is shown as $R_B$ equalling the transfer impedance of the coil. The combination of the passive and active integrators produces a current measurement voltage according to

$$U_s(s) = sMI(s) \frac{1}{1 + sT_{ip}} \frac{1 + sT_{ia}}{sT_{ia}}, \qquad (3)$$

where I(s) is the measured current, $T_{ip}$ is the integration time for the passive integrator, and $T_{ia}$ is the integration time of the active integrator. Equation (3) neglects the effect of the low-pass filter network 24 in Figure 2 on low frequency signals. The low-pass filter network 24 is needed for avoiding saturation of the active integrator owing to low frequency voltages, such as DC offset voltage, of the operational amplifier $OP_1$.

The integration time of the passive integrator is

$$T_{ip} = R_o C_o, \qquad (4)$$

where $R_o$ and $C_o$ are components in the circuit illustrated in Figure 2. The integration time of the active integrator is

$$T_{ia} = R_1 C_1, \qquad (5)$$

where $R_1$ and $C_1$ are components in the circuit illustrated in Figure 2.

The equation (3) holds as long as $R_o \gg R_B$. By matching the integration time of both the active and passive integrators, the following expression is obtained

$$U_s(s) = \frac{MI(s)}{T_i}, \qquad (6)$$

where $T_i$ is the matched integration time.

According to an embodiment of the invention, the signal from the combination of the integrators is amplified, and this amplified signal is used as an indication of the earth fault current. Further, according to another embodiment, the signal from the combination of the integrators is high-pass-filtered and/or amplified for producing the signal indicating the earth fault.

The use of the amplifier circuit increases the amplitude of the measured signal without altering the frequency response. A high-pass filter is used to eliminate low-frequency noise and DC offset voltage drift from the measurement signal.

By adding an amplifier and a high-pass filter to the measurement analog electronic circuit, the frequency response of the current sensing voltage is

$$U_s(s) = \frac{kMI(s)}{T_i} \frac{sT_{hp}}{sT_{hp} + 1}, \qquad (7)$$

where k is the amplifier gain and $T_{hp}$ is the time constant of the high-pass filter.

In other embodiments of the invention, the passive integrator 22 or the active integrator 23 is utilized exclusively. However, this implementation decreases the operation frequency bandwidth of the detection circuitry as compared with that of the combined and matched integrators.

In the following example, a Rogowski coil is designed to operate as a summation current sensor. The Rogowski coil is designed to measure the linkage current of the input phase and neutral by leading the phase and neutral wires through the coil. The toroid coil is designed according to the following specifications:

- Number of turns: 77
- Inner diameter: 15 mm
- Outer diameter: 25 mm
- Height: 2.5 mm

These specifications are based on the following facts. The number of turns is near the maximal amount of turns that are easily implemented in a printed circuit board. The inner diameter is chosen to fit the 2.5 mm$^2$ wires of the input supply phase and neutral. The outer diameter is chosen to provide a sufficient coupling inductance for the coil. The height of the coil is chosen to be near the height of a printed circuit board which, in normal cases, is 1.6 mm.

According to equation (2), the Rogowski coil has a coupling inductance of 19.7 nH. The integrator of the Rogowski coil is implemented using a combination of a passive integrator and an active integrator as described above. The integration time constant of the active and passive integrators is chosen to be 1.87 $\mu$s. According to equation (6), this configuration gives a sensing voltage of 10.5 mV/A.

A non-inverting amplifier and a high-pass filter are added between the passive and active integrator. The amplifier is designed to amplify the measurement signal by a factor of eleven. The high-pass filter is designed to remove the DC offset of the operational amplifier from the measurement signal. The cutoff frequency of the high pass filter is chosen to be approximately 10 Hz in order to keep the measurement signal of the power grid frequency virtually intact.

By means of the above-described example, earth fault currents can be detected in a reliable manner. Simulations and tests show that the operation of the detection is quick and reliable with higher currents that may harm the semiconductor components in the inverter bridge. Additionally, it is verified that the measurement signal of the earth fault detection circuit is sufficient to distinguish lower fault currents that may disturb the motor control from noise produced by the frequency converter.

Since the Rogowski coil does not saturate even at high currents, the same design of the detection circuit of the invention is suitable for wide power ranges. Furthermore, the combination of the active and the passive integrators provides the detection circuit with a wide operation bandwidth.

According to another embodiment of the invention, the circuit board on which the Rogowski coil is integrated is adapted to form a separate measurement board. The same circuit board may also include other circuits relating to the measurement, such as one or both integrators and one or more of the high-pass or low-pass filters. Such an independent and separate measurement board may then be used in connection with a frequency converter that has a suitable input for receiving the voltage signal representing the summation current.

The invention also relates to a frequency converter having an earth fault detection circuit of the invention. This kind of frequency converter is protected against earth faults by using the detection circuit. The detection circuit may be integrated either on an existing circuit board in the converter, such as the main circuit board, or on a separate printed circuit board.

It will be obvious to a person skilled in the art that the inventive concept can be implemented in various ways. The invention and its embodiments are not limited to the examples described above but may vary within the scope of the claims.

**Claims**

1. An earth fault detection circuit for a frequency converter, **characterized in that** the earth fault detection circuit comprises
a Rogowski coil integrated on a circuit board, the Rogowski coil being adapted to produce a voltage signal representing a summation current of an input of the frequency converter or a summation current in the intermediate DC link.

2. An earth fault detection circuit according to claim 1, **characterized in that** the earth fault detection circuit comprises a combination of a passive integrator circuit and an active integrator circuit adapted to receive the voltage signal representing the summation current from the Rogowski coil, wherein the integration times of a passive integrator and an active integrator are the same, and wherein the combination of the integrators is adapted to produce a signal for indicating an earth fault.

3. An earth fault detection circuit according to claim 1, **characterized in that** the earth fault detection circuit comprises a passive integrator circuit adapted to receive the voltage signal representing the summation current from the Rogowski coil, wherein the integrator is adapted to produce a signal for indicating an earth fault.

4. An earth fault detection circuit according to claim 1, **characterized in that** the earth fault detection circuit comprises an active integrator circuit adapted to receive the voltage signal representing the summation current from the Rogowski coil, wherein the integrator is adapted to produce a signal for indicating an earth fault.

5. A circuit according to claims 1 to 4, **characterized in that** the Rogowski coil is adapted to surround the input phase conductors of the frequency converter.

6. A circuit according to claims 1 to 4, **characterized in that** the Rogowski coil is adapted to surround the intermediate DC link conductors of the frequency converter.

7. A circuit as claimed in any one of claims 1 to 6, **characterized in that** the circuit further comprises a high-pass filter adapted to high-pass filter the signal from the combination of integrators for producing a signal for indicating an earth fault.

8. A circuit as claimed in any one of claims 1 to 7, **characterized  in that** the circuit further comprises an amplifier circuit adapted to amplify the signal from the combination of integrators or from the high-pass filter for producing a signal for indicating an earth fault.

9. A circuit as claimed in any one of claims 1 to 8, **characterized in that** the Rogowski coil is formed directly on the surface of the circuit board, the circuit board being a printed circuit board and a winding of the coil being formed by conducting traces on different layers of the printed circuit board and by vias connecting the traces on the different layers.

10. A circuit as claimed in any one of claims 1 to 9, **characterized in that** the circuit board on which the Rogowski coil is integrated is adapted to hold the passive integrator and/or the active integrator circuits.

11. A circuit as claimed in any one of claims 1 to 10, **characterized in that** the circuit board on which the Rogowski coil is integrated is adapted to hold circuitry of the frequency converter.

12. A circuit as claimed in any one of claims 1 to 11, **characterized in that** the circuit board on which the Rogowski coil is integrated is adapted to form a separate measurement board.

13. A frequency converter comprising a circuit according to any one of claims 1 to 12.

FIG 1

FIG 2

FIG 3

FIG 4

Europäisches
Patentamt

European
Patent Office

Office européen
des brevets

# EUROPEAN SEARCH REPORT

Application Number

EP 12 17 1153

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KOJOVIC L A ED - INSTITUTE OF ELECTRICAL AND ELECTRONICS ENGINEERS: "Split-core PCB rogowski coil designs and applications for protective relaying", 2003 IEEE PES TRANSMISSION AND DISTRIBUTION CONFERENCE. CONFERENCE PROCEEDINGS. DALLAS, TX, SEPT. 7 - 12, 2003; [IEEE/PES TRANSMISSION AND DISTRIBUTION CONFERENCE AND EXPOSITION], NEW YORK, NY : IEEE, US, vol. 1, 7 September 2003 (2003-09-07), pages 269-273, XP010725140, DOI: 10.1109/TDC.2003.1335233 ISBN: 978-0-7803-8110-0 * the whole document * | 1-13 | INV. G01R31/02 |
| X | LJUBOMIR A KOJOVIC ET AL: "Comparative characteristics of iron-core current transformers and Rogowski Coils for applications for protective relaying purposes", PROTECTIVE RELAY ENGINEERS, 2009 62ND ANNUAL CONFERENCE FOR, IEEE, PISCATAWAY, NJ, USA, 30 March 2009 (2009-03-30), pages 527-535, XP031461769, ISBN: 978-1-4244-4182-2 * the whole document * | 1-13 | TECHNICAL FIELDS SEARCHED (IPC) G01R |
| A | EP 0 573 350 A1 (GEC ALSTHOM T & D SA [FR]) 8 December 1993 (1993-12-08) * the whole document * | 1-13 | |

The present search report has been drawn up for all claims

| Place of search | Date of completion of the search | Examiner |
|---|---|---|
| Munich | 15 November 2012 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 12 17 1153

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2012

| Patent document cited in search report | Publication date | Patent family member(s) | Publication date |
|---|---|---|---|
| EP 0573350 A1 | 08-12-1993 | DE 69304999 D1 | 31-10-1996 |
| | | EP 0573350 A1 | 08-12-1993 |
| | | FR 2692074 A1 | 10-12-1993 |
| | | JP 3490737 B2 | 26-01-2004 |
| | | JP 6176947 A | 24-06-1994 |
| | | US 5414400 A | 09-05-1995 |

EPO FORM P0459

For more details about this annex : see Official Journal of the European Patent Office, No. 12/82

EP 2 672 282 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5214575 A
- US 7663850 B
- US 5414400 A

### Non-patent literature cited in the description

- **RAY, W.F. ; DAVIS, R.M.** High Frequency Improvements in Wide Bandwidth Rogowski Current Transducer. *European Power Electronics Conference, Conference Proceedings, Lausanne,* 1999